# EUROPEAN PATENT APPLICATION

(11) **EP 2 578 614 A1**
(43) Date of publication of application: **10.04.2013**
(21) Application number: 10851939.8
(22) Date of filing: 24.05.2010
(51) Int. Cl.: C08G 61/12, H01L 51/42

(54) **QUINOXALINE CONJUGATED POLYMER CONTAINING FUSED-RING THIOPHEHE UNIT, PREPARATION METHOD AND USES THEREOF**

(71) Applicant: Ocean's King Lighting Science&Technology Co., Ltd., Guangdong 518052 (CN)
(72) Inventor: ZHOU, Mingjie, Shenzhen, Guangdong 518054 (CN); HUANG, Jie, Shenzhen, Guangdong 518054 (CN); XU, Erjian, Shenzhen, Guangdong 518054 (CN)
(74) Representative: Wallinger, Michael
(86) International application number: PCT/CN2010/073104
(87) International publication number: WO 2011/147067

(57) **Abstract**

A quinoxaline conjugated polymer containing fused-ring thiophene unit is disclosed, and the general formula of molecular structure thereof is formula (I). In the formula, x+y=2, 1≤ x< 2, n is an integer and 1< n≤ 100, R1, R2 are selected from C₁∼C₂₀ alkyl, R3, R4 are selected from -H, C₁∼C₂₀ alkyl, C₁∼C₂₀ alkoxy, benzene ring group containing alkyl or alkoxy, fluorene group containing alkyl or carbazole group containing alkyl. The polymer is useful in the fields of solar battery and the like.

## Description

### TECHNICAL FIELD

This invention relates to the technical field of synthesize of organic compound, particularly, to a quinoxaline conjugated polymer containing fused-ring thiophene unit, preparation method and uses thereof.

### BACKGROUND

It is a hot issue and difficult point in the photovoltaic field to make low cost and high efficient solar cell from cheap material. Nowadays, the application of the silicon solar cell module for ground is restricted by its complicated manufacture process and high cost. In order to reduce the cost and expand the extent of application, new material for solar cell has long been looked for. Polymer solar cell has been focused on because of the advantages of raw material with low cost, the cell having lightweight, flexibility, easy to produce, and may be produced in a large area by coating and printing. And the polymer solar cell will have a large market prospect if the energy conversion efficiency thereof can be increased to the level close to that of commercial available silicon solar cell. In 1992, N. S. Sariciftci et al reported in SCIENCE the phenomenon that the light induced electron may be transferred between a conjugated polymer and the C60, since then, a lot of research about the polymer solar cell has been carried out, and has an increasing development. At present, the research about polymer solar cell is mainly focused on the donor-acceptor blends, among others the energy conversion efficiency of the PTB7 and PC₇₁BM blend has been increased to 7.4%, which is still much lower than that of inorganic solar cell. The main factors that limit the improving of performance of the organic solar cell are: the relatively low carrier mobility of the organic semiconductor element, the spectral response of the element not matching the solar radiation spectrum, the red light region with high photon flux not being effectively utilized and the low carrier collecting efficiency of the electrode and the like. To make practical use of the polymer solar cell, the development of new type of material and significantly increasing of its energy conversion efficiency is still the primary task in this field.

### SUMMARY

A technical problem solved by the present invention is to provide a quinoxaline conjugated polymer containing fused-ring thiophene unit, which has an effectively extended conjugacy, a lower band gap, and facilitates the transfer of carrier between two main chains, thereby improves the mobility of the carrier, meanwhile, the process of introducing electron donator and electron acceptor is simplified, thus the characteristic of electron withdrawing of the polymer is modulated.

Another object of the present invention is to provide a preparation method of a quinoxaline conjugated polymer containing fused-ring thiophene unit, which is simple, has high yield, and easy to operate and control.

A further object of the present invention is to provide a use of the above-mentioned quinoxaline conjugated polymer containing fused-ring thiophene unit in the field of organic photoelectric material, polymer solar cell, organic electroluminescent element, organic field effect transistor, organic optical storage element, organic nonlinear material and/or organic laser element.

The above-mentioned technical problems can be solved through the following technical solutions: a quinoxaline conjugated polymer containing fused-ring thiophene unit, the general formula (I) thereof is:

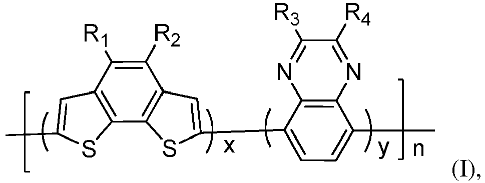

wherein, x+y=2, 1≤x < 2, n is an integer and 1< n ≤100, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl.

And a method for manufacturing a quinoxaline conjugated polymer containing fused-ring thiophene unit, comprising:

Compounds A, B, C with following structural formulae are provided separately,

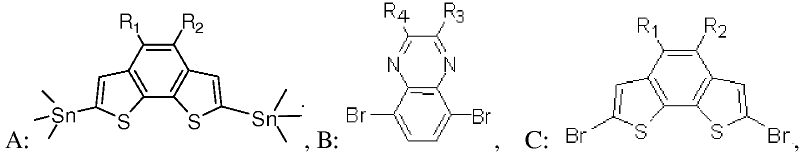

wherein, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl;

under an inert gas atmosphere and with the present of catalyst and organic solvent, the Stille coupling of compounds A, B, C in a molar ratio of m:p:q is carried out to give the quinoxaline conjugated polymer containing fused-ring thiophene unit represented by general formula (I), wherein, m = p + q , and m > q≥0 ,

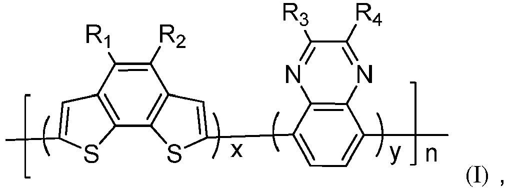

in general formula (I), x + y = 2, 1≤x < 2 , n is an integer and 1 < n≤100.

Furthermore, the application of the quinoxaline conjugated polymer containing fused-ring thiophene unit according to the present invention in the field of organic photoelectric material, polymer solar cell, organic electroluminescent element, organic field effect transistors, organic optical storage element, organic nonlinear material and/or organic laser element is provided.

The major advantages of the present invention compared to the prior art are as follows:
1. the benzo[2,1-b: 3,4-b'] dithiophene unit in the quinoxaline conjugated polymer molecules containing fused-ring thiophene unit has a rigid crystalline structure, the two thiophene rings thereof are in the same plane, and because of this unit, the conjugacy and coplanarity of the conjugated polymer molecule of the present invention are effectively increased, and the delocalization of electron is facilitated, the conjugacy of the molecules are effectively extended, and the band gap of the polymer is lowered, the transfer of carrier between two main chains is facilitate, and the mobility of carrier is improved;
2. meanwhile the quinoxaline structural unit thereof is a good acceptor unit with strong electron withdrawing, the present of this quinoxaline structural unit endows the polymer of the present invention with high electron mobility, high glass transition temperature, superior electrochemistry reducibility, on the other hand this quinoxaline structural unit has good modifiability, which makes the introduction of electron donator and electron acceptor to the polymer of the present invention much easier and the electron withdrawing of the polymer may be improved;
3. as the quinoxaline conjugated polymer containing fused-ring thiophene unit comprises both benzo[2,1-b: 3,4-b']dithiophene and quinoxaline structural units, the application of the polymer in the field of organic photoelectricity material, polymer solar cell, organic electroluminescent element, organic field effect transistors, organic optical storage element, organic nonlinear material and/or organic laser element is extended;
4. the process of producing the quinoxaline conjugated polymer containing fused-ring thiophene unit is simple, and has a high yield, the reacting condition thereof is mild, easy to operate and control, and suitable for industrial production.

### BRIEF DESCRIPTION OF THE DRAWINGS

FIG. 1 is a schematic view of the general formula of the quinoxaline conjugated polymer containing fused-ring thiophene unit according to the embodiments of the present invention;

FIG. 2 is a structural schematic view of a polymer solar cell device comprising the quinoxaline conjugated polymer containing fused-ring thiophene unit prepared in Example 1 as an active layer;

FIG. 3 is a structural schematic view of an organic electroluminescence device comprising the quinoxaline conjugated polymer containing fused-ring thiophene unit prepared in Example 1 as an active layer;

FIG. 4 is a structural schematic view of an organic field effect transistor device comprising the quinoxaline conjugated polymer containing fused-ring thiophene unit prepared in Example 1 as an organic semiconductor layer.

### DETAILED DESCRIPTION OF THE PREFERRED EMBODIMENTS

Objects, advantages and embodiments of the present invention will be explained below in detail with reference to the embodiments. However, it is to be appreciated that the following description of the embodiments is merely exemplary in nature and is no way intended to limit the invention, its application, or uses.

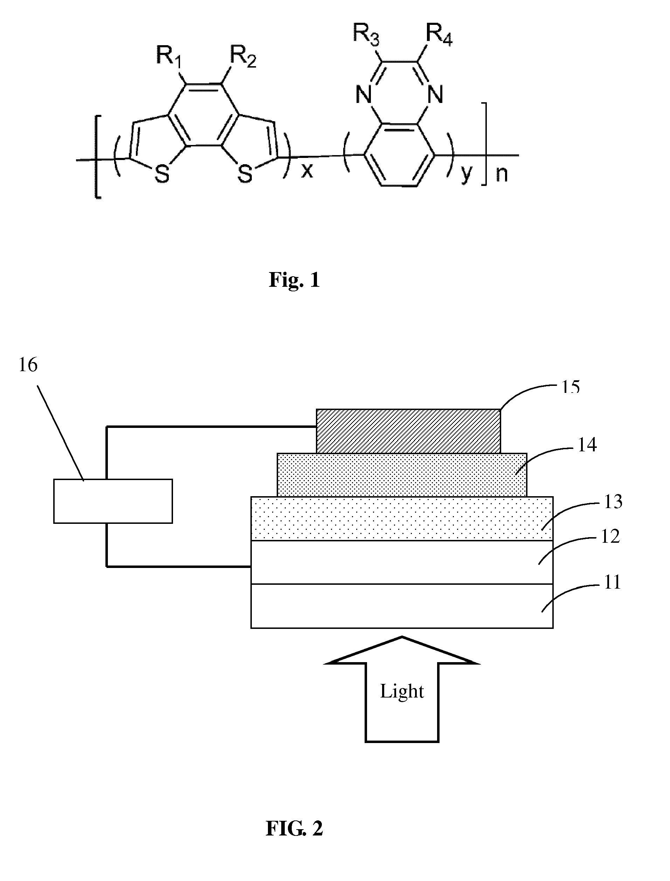

Referring to FIG. 1, a quinoxaline conjugated polymer containing fused-ring thiophene unit according to the embodiments of the present invention is shown, the general formula (I) thereof is:

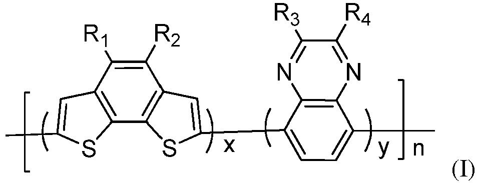

wherein, x+y=2, 1≤x < 2, n is an integer and 1< n ≤100, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl.

The general formula of the above fluorenyl group containing alkyl is as follows:

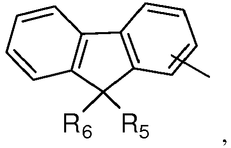

wherein R₅ and R₆ are same or different, each represents C₁ ∼ C₂₀ alkyl;

the general formula of the above carbazyl group containing alkyl is as follows:

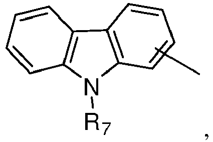

wherein, R₇ represents C₁ ∼ C₂₀ alkyl;

the general formula of the above benzene ring group containing alkyl is as follows:

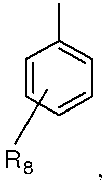

wherein R₈ is selected from the group consisting of C₁∼C₂₀ alkyl and C₁∼C₂₀ alkoxyl.

The benzo[2,1-b: 3,4-b'] dithiophene unit in the quinoxaline conjugated polymer containing fused-ring thiophene unit has a rigid crystalline structure, wherein two thiophene rings thereof are in the same plane, and because of this unit, the conjugacy and coplanarity of the conjugated polymer molecule of the present invention are effectively increased, and the delocalization of electron is facilitated, the conjugacy of the molecules are effectively extended, and the band gap of the polymer is lowered, the transfer of carrier between two main chains is facilitate, and the mobility of carrier is improved; meanwhile the quinoxaline structural unit thereof is a good acceptor unit with strong electron withdrawing, the present of this quinoxaline structural unit endows the polymer of the present invention with high electron mobility, high glass transition temperature, superior electrochemistry reducibility, on the other hand, this quinoxaline structural unit has good modifiability, which makes the introduction of electron donator and electron acceptor to the polymer of the present invention much easier and the electron withdrawing of the polymer may be improved.

Also, the embodiments of the present invention also provide a method of manufacturing a quinoxaline conjugated polymer containing fused-ring thiophene unit, comprising the following steps:

(1) Compounds A, B and C with following formulae are provided separately:

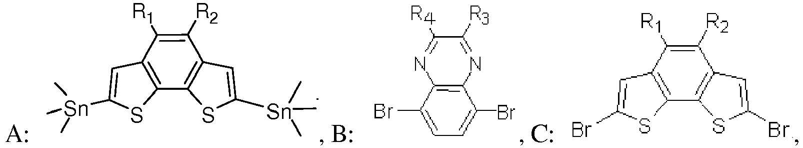

wherein, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl;

(2) under an inert gas atmosphere and with the present of catalyst and organic solvent, the Stille coupling of compounds A, B, C in a molar ratio of m:p:q is carried out to give the quinoxaline conjugated polymer containing fused-ring thiophene unit represented by general formula (I), wherein, m = p + q , and m > q≥0 ,

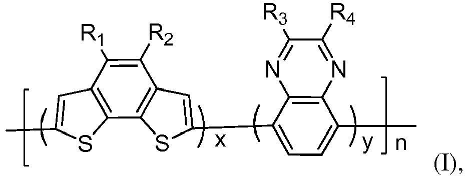

in general formula (I), x + y = 2, 1≤x < 2 , n is an integer and 1 < n≤100;

the chemical equation of the Stille coupling reaction is:

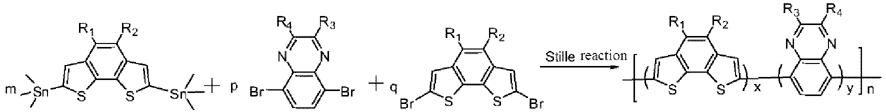

Compounds A and C in the above step (1) may be prepared according to the step (2) of Example 1, and the method for producing compound B preferably includes following steps:

At the temperature of 20 ∼ 120° C and with the present of organic solvent, the dehydration reaction of compounds diketone and 3,6 - dibromo-o-phenylene diamine in a molar ratio of 1: 0.1∼10 are carried out for 1 ∼ 24 h to give the said compound B, wherein the organic solvent employed in the dehydration reaction is preferably at least one selected from the group consisting of acetic acid, m-cresol, p-toluenesulfonic acid, chloroform, methanol, ethanol and butanol, and the amount thereof is at least that ensures the dehydration reaction proceed to completion. The chemical equation thereof is:

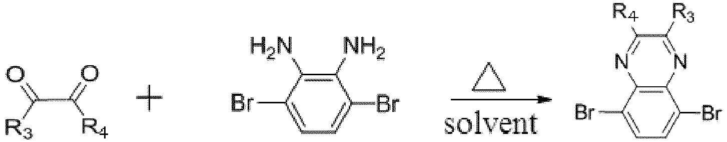

In the Stille coupling reaction of the above step (2), when the addition amount of the compound C is 0, i.e. q =0, only compounds A and B take part in this reaction, and the compounds A and B take part in the Stille coupling reaction in equimolar amounts, to give the quinoxaline conjugated polymer containing fused-ring thiophene unit of general formula (I), with the proviso that x + y = 2 , and x=y=1; when the addition amount of compound C is not 0, i.e. q≠0, all the compounds A, B and C take part in the Stille coupling reaction, to give the quinoxaline conjugated polymer containing fused-ring thiophene unit of general formula (I), with the proviso that x + y = 2 , and x≠y≠1. Compound C (i.e. 2, 7-dibromo- benzo [2, 1-b: 3, 4-b'] dithiophene) is commercial available or can be produced by conventional method in this art, and compound A can be produced by conventional method in this art. The amount of the catalyst in this Stille coupling reaction is preferably 0.05% ∼ 50% molar percent of compound A; preferably, this catalyst is organic Pd catalyst or a blend of organic Pd catalyst and organic phosphine ligand, wherein the organic Pd catalyst is preferably at least one member selected from of the group consisting of Pd₂(dba)₃, Pd(PPh₃)₄, Pd(PPh₃)₂Cl₂, the organic phosphine ligand is preferably, but not limited to, P(o-Tol)₃ ; when the catalyst is a blend of organic Pd catalyst and organic phosphine ligand, the molar ratio of the organic Pd catalyst/organic phosphine ligand is 1:2 ∼ 20.

The organic solvent employed in the abovementioned Stille coupling reaction is preferably one or more selected from the group consisting of tetrahydrofuran, ethylene glycol dimethyl ether, benzene, chlorobenzene, toluene, and the amount thereof is at least that ensures the Stille coupling reaction proceed to completion.

The reaction temperature of the abovementioned Stille coupling reaction is preferably 60 ∼ 130°C, and the duration thereof is preferably 24 ∼ 72h.

A catalyst is necessary for the abovementioned Stille coupling reaction, as a result of that a middle product is yielded by the catalyst with a reagent in the Stille coupling reaction, thereby the Stille coupling reaction is carried out.

The above Stille coupling reaction should be carried out in an oxygen-free condition, as the reactants in the Stille coupling reaction and the oxygen are active, when the oxygen enters into the reaction circumstance, it will react with the reactants firstly, and the oxygen frustrates the formation of the intermediate product, thereby the Stille coupling reaction fails. The oxygen-free circumstance may be achieved by evacuating or being filled with inert gas, and preferably by being filled with inert gas, the inert gas is well known to one skilled in the art, e.g. nitrogen, argon and the like, and the nitrogen is preferred.

In the process of producing the quinoxaline conjugated polymer containing fused-ring thiophene unit, the reactants are added in a certain ratio, and no other special devices or special circumstance are needed, and the process is simple and has a high yield, the reaction condition is mild, easy to operate and control, and suitable for industrial production.

The abovementioned quinoxaline conjugated polymer containing fused-ring thiophene unit contains both benzo[2,1-b: 3,4-b'] dithiophene and quinoxaline structural units, thus the quinoxaline conjugated polymer containing fused-ring thiophene unit may be applied in the field of organic photoelectricity material, polymer solar cell, organic electroluminescent elements, organic field effect transistors, organic optical storage elements, organic nonlinear material and/or organic laser elements.

The present invention will be explained in detail referring to Examples.

**Example 1**

The conjugated polymer of this Example is 4,5- dialkyl- benzo [2,1-b :3,4-b'] dithiophene -2,3 bis (phenyl) quinoxaline conjugated polymer, it is represented by formula I₁:

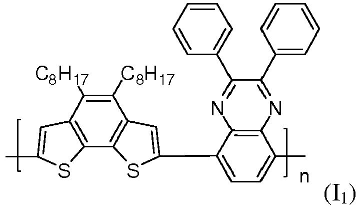

The preparation of the conjugated polymer of this Example is as follows:

1) Preparation of 5,8-dibromo-2,3-bis(phenyl)quinoxaline, the chemical equation thereof is:

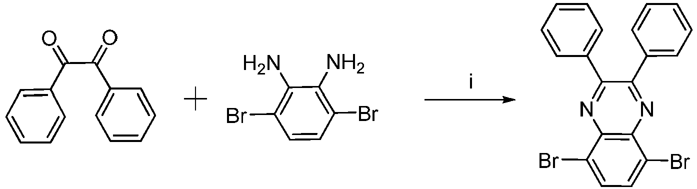

The detailed preparation procedure is as follows: 3, 6-dibromo-o-phenylene diamine (1.0 g, 3.7 mmol) was added to a solution of compound benzil (0.39 g, 1.84 mmol) in acetic acid (20mL) at 120° C, and then mixed uniformly. After refluxed for 12 hours, the fluid reactant was poured into water, and neutralized with sodium bicarbonate until neutral, then extracted with chloroform and washed with saturated brine, dried over anhydrous sodium sulfate, then it was vacuum evaporated to remove the solvent, and the resulting crude product was purified by column chromatography to give a white solid, and then recrystallized from chloroform / n-hexane to give a white solid powder. The test result is: MS (EI) m/z: 440(M⁺).

2) Preparation of 2,7 - bis-trimethyl-tin - 4,5 - dialkyl- benzo[2,1-b: 3,4-b'] dithiophene, the chemical equation thereof is:

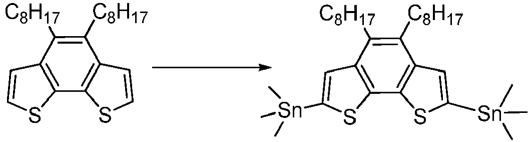

The detailed preparation procedure is: according to Macromolecules *2008, 41,* 5688, t-BuLi (5.3 mL, 1.4 mol / L, 7.5 mmol) was added dropwise to a solution of 4,5-dioctyl- benzo[2,1-b: 3,4-b'] dithiophene (1.03 g , 2.5mmol) in tetrahydrofuran (100 mL) at -78 °C, then the mixture was slowly warmed up to room temperature, and stirred for 0.5 h, then cooled to -78 °C. Trimethyltin chloride (7.5mmol , 7.5mL) was added dropwise to the above solution, and the solution was naturally warmed up to room temperature, stirred for 20 hours, then the reaction was quenched by water, followed by rotary evaporation to remove the tetrahydrofuran, then extracted with chloroform / water, washed with water, dried over anhydrous sodium sulfate, thus the organic phase was removed to give a brown solid in 54% yield. The test result is: MS (MALDI) m/z: 617(M⁺).

3) Synthesis of 4,5- dioctyl- benzo [2,1-b :3,4-b '] dithiophene -quinoxaline conjugated polymer I₁, the chemical equation thereof is as follows:

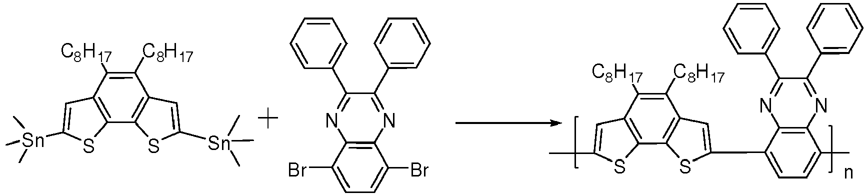

The detailed preparation procedure is: under the protection of nitrogen, a solution of compounds 5,8 - dibromo-2 ,3 - bis (phenyl) quinoxaline (0.22 g, 0.5 mmol) and 2,7 - bis-trimethyltin - 4,5-dioctyl-benzo [2,1-b :3,4-b'] dithiophene (0.37 g, 0.5 mmol) in chlorobenzene (20 mL) was bubbled with nitrogen for 0.5 h to remove the oxygen in the environment, then Pd₂(dba)₃(0.014 g , 0.015 mol)and P(o-Tol)₃ (0.0083 g , 0.027 mmol) were added, and the solution was bubbled with nitrogen for another 1 h to remove residual oxygen and then heated to 60 °C under reflux for 72 hours. The resulting mixture was added dropwise to methanol to conduct a sedimentation, then the resulting product was vacuum filtrated, and washed with methanol and dried, then dissolved in chlorobenzene and the solution was added to aqueous sodium diethyldithiocarbamate solution and heated to 80 °C with stirring for 12 hours, then it was allowed to stand until the layers separated. The organic phase was passed through a column chromatography of alumina, eluted in chloroform, then it was concentrated under reduced pressure to remove the organic solvent, followed by methanol sedimentation and vacuum filtration, and a solid was obtained. Then the solid was Soxhlet extracted with acetone for 72 hours, followed by methanol sedimentation and vacuum filtration to give the final product in 49%. The Molecular weight of the final products: (GPC, THF, R. I): Mn = 31,500, M_{w}/Mₙ = 1.9).

**Example 2**

The conjugated polymer of this Example is 4,5- dialkyl- benzo [2,1-b :3,4-b'] dithiophene -2,3 bis (phenyl) quinoxaline conjugated polymer, it is represented by formula I₂:

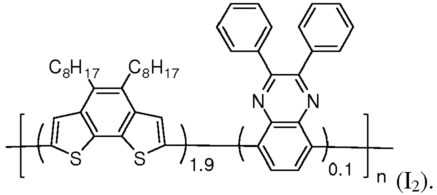

The preparation of the conjugated copolymer of this Example is as follows:

Steps 1) and 2) of this preparation are the same as those of Example 1;

3) Synthesis of 4,5 - dioctyl benzo [2,1-b :3,4-b'] dithiophene - quinoxaline conjugated polymer of formula I₂, the chemical equation thereof is as follows:

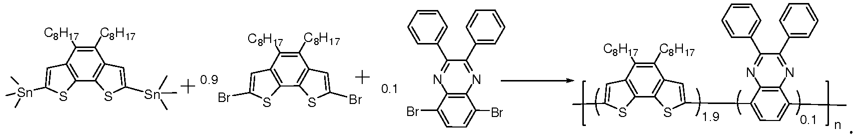

The detailed preparation procedure is: under the protection of argon, a solution of compounds 5,8 - dibromo-2,3 - bis (phenyl) quinoxaline (0.022 g, 0.05 mmol), 2,7 - dibromo - 4,5 - dioctyl benzo[2,1-b :3,4-b'] dithiophene (0.26 g, 0.45 mmol) and 2,7 - bis-trimethyltin - 4,5 - dioctyl benzo[2,1-b :3,4-b'] dithiophene (0.37 g, 0.5 mmol) in benzene (20 mL) was bubbled with nitrogen for 0.5 h to remove the oxygen in the reaction environment, then Pd₂(dba)₃ (0.014 g, 0.015 mol) and P(o-Tol)₃(0.0083 g, 0.027 mmol) were added, and the solution was bubbled with nitrogen for another 1 h to remove residual oxygen and then heated to 130° C under reflux for 24 hours. The resulting mixture was added dropwise to methanol to conduct a sedimentation, followed by vacuum filtration, the resulting product was washed with methanol, and dried, then dissolved in chlorobenzene and the resulting solution was added to aqueous sodium diethyldithiocarbamate solution, and the resulting mixture was heated to 80 °C with stirring for 15 hours, then it was allowed to stand until the layers separated. The organic phase was passed though a chromatography column of alumina, and eluted in chloroform, and concentrated under reduced pressure to remove the organic solvent, followed by methanol sedimentation, and vacuum filtration to give a solid. The resulting solid was Soxhlet extracted with acetone for 72 hours, followed by methanol sedimentation, vacuum filtration, to give the final product in 66% yield. The Molecular weight of the final product (GPC, THF, R. I): Mₙ = 39,500, M_{w}/Mₙ = 2.1).

**Example 3**

The conjugated polymer of this Example is 4,5- dialkyl- benzo [2,1-b :3,4-b'] dithiophene -2,3 bis (phenyl) quinoxaline conjugated polymer, it is represented by formula I₃:

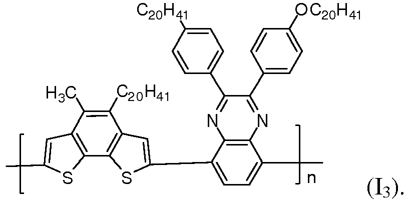

Preparation of the conjugated polymer of this Example is as follows:

1) A compound of 5,8-dibromo-2- (4-n-eicosylphenyl) 3-(4-n-eicosyloxy phenyl) quinoxaline of structural formula I₃' was prepared in the same procedure and under the similar conditions as step 1) in Example 1 ,

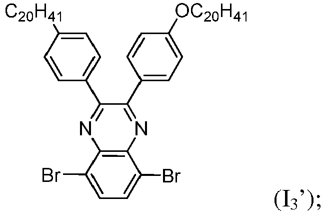

2) A compound of 2,7 - bis-trimethyltin - 4-methyl-5- n-eicosyl-benzo[2,1-b: 3,4-b'] dithiophene of formula I₃" was prepared in the same procedure and under the similar condition as the step 2) in Example 1;

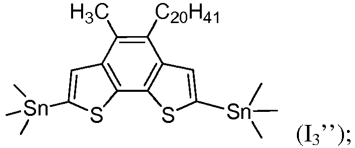

3) Synthesis of 4-methyl-5- n-eicosyl- benzo[2,1-b: 3,4-b'] dithiophene-quinoxaline conjugated polymer of formula I₃, the chemical equation thereof is as follows:

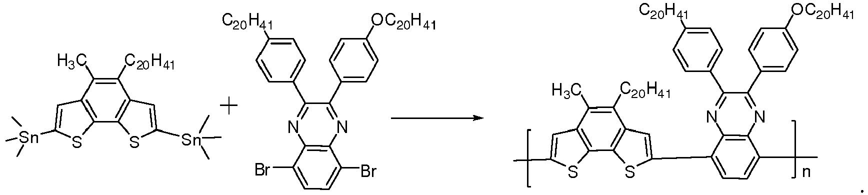

The detailed preparation procedure is: under the protection of nitrogen, a solution of compounds 5,8 - dibromo-2 -(4-n-eicosylphenyl)3-(4-n-eicosyloxyphenyl) quinoxaline (0.51 g, 0.5 mmol), 2,7 - bis-trimethyltin -4- methyl-5- n-eicosyl-benzo[2,1-b: 3,4-b'] dithiophene (0.41 g, 0.5 mmol) in glycol dimethyl ether (20 mL) was bubbled with nitrogen for 0.5 h to remove the oxygen in the reaction environment, then Pd₂(dba)₃ (0.014 g ,0.015 mol) and P(o-Tol)₃(0.0083 g ,0.027 mmol) were added, and the solution was bubbled with nitrogen for another 1 h to remove residual oxygen and then heated to 100°C under reflux for 72 hours. The resulting mixture was added dropwise to methanol to conduct a sedimentation, followed by vacuum filtration, then washed with methanol, and dried, then dissolved in chlorobenzene and the resulting solution was added to aqueous sodium diethyldithiocarbamate solution, and the mixture was heated to 80 °C with stirring for 8 hours, and the mixture was allowed to stand until the layers separated. The organic phase was passed through a chromatography column of alumina, then eluted in chloroform, and concentrated under reduced pressure to remove the organic solvent, followed by methanol sedimentation and vacuum filtration to afford a solid. The solid was Soxhlet extracted with acetone for 72 hours, followed by methanol sedimentation, vacuum filtration, to give the product in 58% yield. The Molecular weight of the title product (GPC, THF, R. I): *Mₙ* = 78,500, *M*_{*w*/}*Mₙ* = 2.3).

**Example 4**

The conjugated polymer of this Example is 4,5- dialkyl- benzo [2,1-b :3,4-b'] dithiophene -2,3 bis (phenyl) quinoxaline conjugated polymer, it is represented by formula I₄:

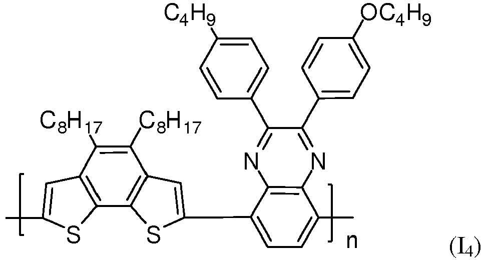

The preparation of the conjugated polymer of this Example is as follows:

1) A compound of 5,8-dibromo-2-(4-n-butylphenyl) 3-(4-n-butoxyphenyl) quinoxaline of following formula I₄' is prepared in the same procedure and under the similar conditions as step 1) in Example 1,

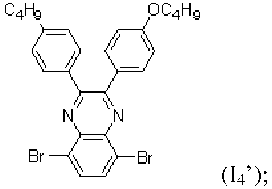

2) A compound of 2,7 - bis-trimethyltin - 4,5- dialkyl- benzo[2,1-b: 3,4-b'] dithiophene was prepared in the same procedure as step 2) in Example 1;

3) Synthesis of 4,5-dioctyl benzo [2,1-b :3,4-b'] dithiophene- quinoxaline conjugated polymer of formula I₄, the chemical equation thereof is as follows:

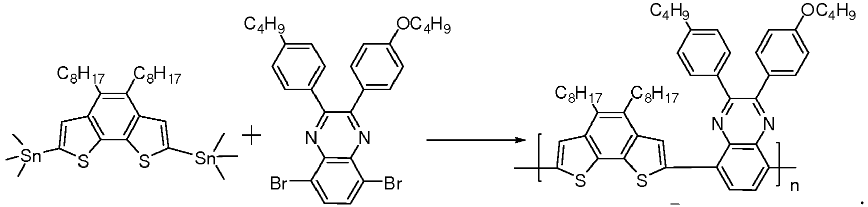

The detailed preparation procedure is: under the protection of nitrogen, a solution of compounds 5,8 - dibromo-2 -(4-n-butylphenyl) 3-(4-n-butoxyphenyl) quinoxaline (0.28 g, 0.5 mmol), 2,6 - bis-trimethyltin - N - octylbisthieno [3,2-b: 2', 3'-d] pyrrole (0.31 g, 0.5 mmol) in tetrahydrofuran (15 mL) was bubbled with nitrogen for 0.5 h to remove the oxygen in the reaction environment, then Pd(PPh₃)₂Cl₂ (0.030 mmol) was added, and the solution was bubbled with nitrogen for another 1 h to remove residual oxygen and then heated to 100° C under reflux for 24hours. The resulting mixture was added dropwise to methanol to conduct a sedimentation, followed by vacuum filtration, then washed with methanol and dried, then dissolved in chlorobenzene and the resulting solution was added to aqueous sodium diethyldithiocarbamate solution, and then the mixture was heated to 80 °C with stirring for 6 hours, and the mixture was allowed to stand until the layers separated. The resulting organic phase was passed through a chromatography column of alumina, eluted in chloroform, and concentrated under reduced pressure to remove the organic solvent, followed by methanol sedimentation and vacuum filtration and a solid was afforded. The resulting solid was Soxhlet extracted with acetone for 72 hours, followed by methanol sedimentation and vacuum filtration to give the final product. The Molecular weight of the final product (GPC, THF, R. I): Mₙ = 68,500, M_{w}/Mₙ = 1.7).

**Example 5**

The conjugated polymer of this Example is 4,5- dialkyl- benzo [2,1-b :3,4-b'] dithiophene -2,3 bis (phenyl) quinoxaline conjugated polymer, it is represented by formula I₅:

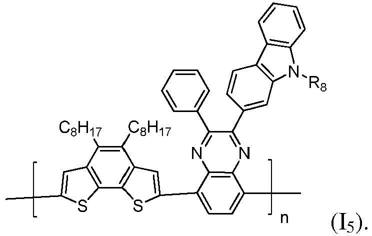

Preparation of the conjugated polymer of this Example is as follows:

1) Preparation of 5,8-dibromo-2-(3-(N-alkylcarbazol)yl)-3-phenyl-quinoxaline of formula I₅':

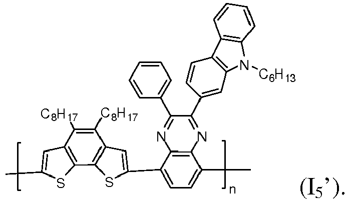

The detailed preparation procedure is: 3, 6- dibromo- o-phenylene diamine (1.0 g, 3.7 mmol) was added to a solution of compound 2-(3-(N-hexylcarbazole)yl) phenylethanedione (0.68 g, 1.78 mmol) in butanol (20 mL) at 120° C, then mixed uniformly, and the mixture was refluxed for 24 hours. The resulting fluid reactant was poured into water, and neutralized with sodium bicarbonate until neutral, then extracted with chloroform and washed with saturated brine, dried over anhydrous sodium sulfate, and the solvent was removed by rotary evaporation to afford a crude product. The crude product was purified by column chromatography to give a white solid, and recrystallized from chloroform / n-hexane to give a solid powder. MS (MALDI) m/z: 614 (M⁺).

2) A compound of 2,7 - bis-trimethyltin - 4,5- dialkyl- benzo[2,1-b: 3,4-b'] dithiophene was prepared in the same procedure as step 2) in Example 1;

3) Synthesis of N- octyl bisthieno [3,2-b:2',3'-d] pyrrole- quinoxaline conjugated polymer of formula I₅, the chemical equation thereof is as follows:

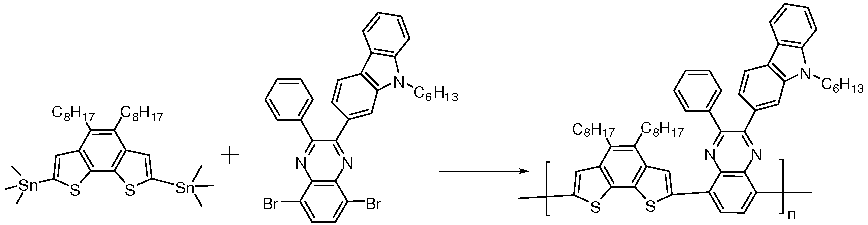

The detailed preparation procedure is: under the protection of nitrogen, a solution of compounds 5,8 - dibromo-2 -(3 - (N-hexylcarbazole)yl-3-phenyl-quinoxaline (0.31 g, 0.5 mmol) and 2,7 - bis-trimethyltin - 4,5- dioctyl- benzo[2,1-b: 3,4-b'] dithiophene (0.37 g, 0.5 mmol) in a mixture (20 mL) of tetrahydrofuran and chlorobenzene with the volume ratio of 1:1 was bubbled with nitrogen for 0.5 h to remove the oxygen in the reaction environment, then Pd₂(dba)₃ (0.014 g, 0.015 mol) and P(o-Tol)₃ (0.0083 g, 0.027 mmol) were added, and the solution was bubbled with nitrogen for another 1 h to remove residual oxygen and then heated to 100 °C under reflux for 72 hours. The resulting mixture was added dropwise to methanol to conduct a sedimentation, and the product was vacuum filtrated, washed with methanol and dried, then dissolved in chlorobenzene and the resulting solution was added to aqueous sodium diethyldithiocarbamate solution, and the mixture was heated to 80 ° C with stirring for 20 hours, the mixture was allowed to stand until the layers separated, the resulting organic phase was passed through a column chromatography of alumina, eluted in chloroform, and concentrated under reduced pressure to remove the organic solvent, followed by methanol sedimentation, then it was vacuum filtrated to give a solid. The resulting solid was Soxhlet extracted with acetone for 72 hours, followed by methanol sedimentation and vacuum filtration to give a product in 48% yield. The Molecular weight of the product (GPC, THF, R. I): Mₙ = 43000, M_{w}/Mₙ = 2.5).

**Example 6**

The conjugated polymer of this Example is 4,5- dialkyl- benzo [2,1-b :3,4-b'] dithiophene -2,3 bis (phenyl) quinoxaline conjugated polymer, it is represented by formula I₆:

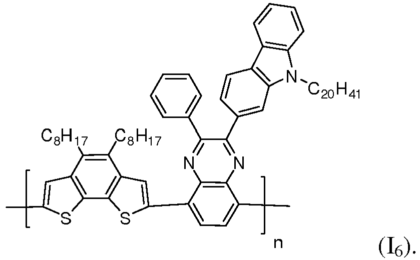

Preparation of the conjugated polymer of this Example is as follows:

1) A compound of 5,8-dibromo-2-(3-(N-n-eicosylcarbazole)yl)-3-phenyl-quinoxaline with the following formula I₆' was prepared in the same procedure and under the similar condition as step 1) of Example 1,

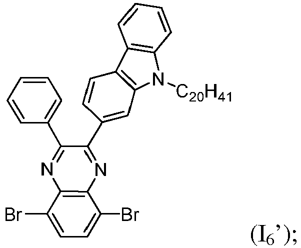

2) A compound of 2,7 - bis-trimethyltin - 4,5- dialkyl- benzo[2,1-b: 3,4-b'] dithiophene was prepared in the same procedure as step 2) in Example 1;

3) Synthesis of 4,5 - dioctyl benzo [2,1-b: 3,4-b'] dithiophene - quinoxaline conjugated polymer of formula I₆, the chemical equation thereof is as follows:

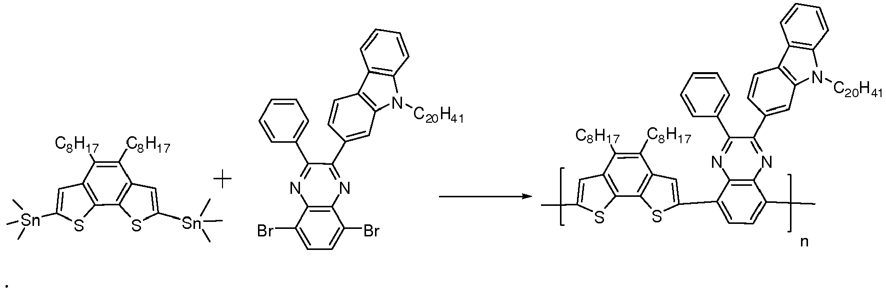

The detailed preparation procedure is: under the protection of nitrogen, a solution of compounds 5,8-dibromo-2-(3-(N-n-eicosylcarbazole)yl)-3-phenyl-quinoxaline (0.41 g, 0.5 mmol) and 2,7 - bis-trimethyltin - 4,5-dioctylbenzo[2,1-b: 3,4-b'] dithiophene (0.37 g, 0.5 mmol) in chlorobenzene (20 mL) was bubbled with nitrogen for 0.5 h to remove the oxygen in the reaction environment, then Pd(PPh₃)₄ (0.015 mol) and Pd(PPh₃)₂Cl₂ (0.027 mmol) were added, and the solution was bubbled with nitrogen for another 1 h to remove residual oxygen and then heated to 100° C under reflux for 72 hours. The resulting mixture was added dropwise to methanol to conduct a sedimentation, then the resulting product was vacuum filtrated, and washed with methanol and dried, then dissolved in chlorobenzene. The resulting solution was added to aqueous sodium diethyldithiocarbamate solution and heated to 80 °C with stirring for 6 hours, then it was allowed to stand until the layers separated. The resulting organic phase was passed through a column chromatography of alumina, eluted in chloroform, and concentrated under reduced pressure to remove the organic solvent, followed by methanol sedimentation and it was vacuum filtrated to afford a solid. The resulting solid was Soxhlet extracted with acetone for 72 hours, followed by methanol sedimentation and it was vacuum filtrated to give the title product of this Example in 53% yield. The Molecular weight of the product( GPC, THF, R. I): Mₙ = 31000, *M_{w}*/*Mₙ* = 1.9).

**Example 7**

The conjugated polymer of this Example is 4,5- dialkyl- benzo [2,1-b :3,4-b'] dithiophene -2,3 bis (phenyl) quinoxaline conjugated polymer, it is represented by formula I₇:

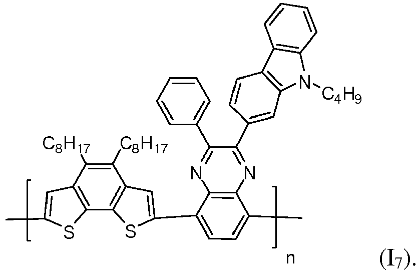

Preparation of the conjugated polymer of this Example is as follows:

1) A compound of 5,8-dibromo-2-(3-(N-n-eicosylcarbazole)yl)-3- phenyl -quinoxaline with the structural formula of following formula I₇' was prepared in the same procedure and under the similar condition as step 1) of Example 1;

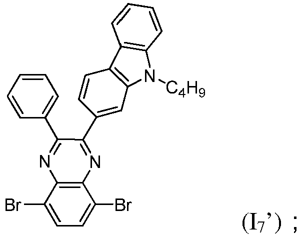

2) A compound of 2,7 - bis-trimethyltin - 4,5- dialkyl- benzo[2,1-b: 3,4-b'] dithiophene was prepared in the same procedure as step 2) in Example 1;

Synthesis of N- octyl bisthieno [3,2-b:2',3'-d] pyrrole- quinoxaline conjugated polymer of formula I₇, the chemical equation thereof is as follows:

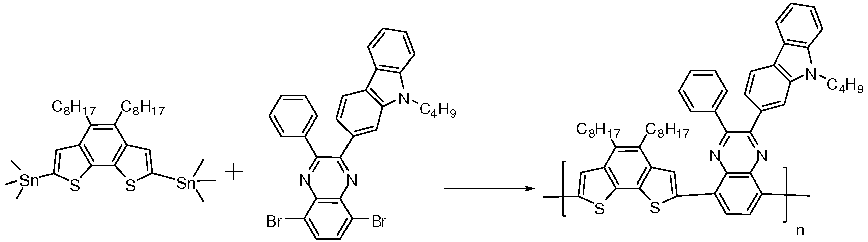

The detailed preparation procedure is: under the protection of nitrogen, a solution of compounds 5,8-dibromo-2-(3-(N-n-butyl carbazole)yl)-3-phenyl-quinoxaline (0.29 g, 0.5 mmol) and 2,7 - bis-trimethyltin - 4,5- dioctyl benzo[2,1-b: 3,4-b'] dithiophene (0.37 g, 0.5 mmol) in chlorobenzene (20 mL) was bubbled with nitrogen for 0.5 h to remove the oxygen in the reaction environment, then Pd₂(dba)₃ (0.014 g, 0.015 mol) and P(o-Tol)₃ (0.0083 g, 0.027 mmol) were added, and the solution was bubbled with nitrogen for another 1 h to remove residual oxygen and then heated to 100°C under reflux for 28 hours. The resulting mixture was added dropwise to methanol to conduct a sedimentation, then the resulting product was vacuum filtrated, and washed with methanol and dried, then dissolved in chlorobenzene. The resulting solution was added to aqueous sodium diethyldithiocarbamate solution and heated to 80 °C with stirring for 20 hours, then it was allowed to stand until the layers separated. The organic phase was passed through a column chromatography of alumina, eluted in chloroform, and concentrated under reduced pressure to remove the organic solvent, followed by methanol sedimentation and it was vacuum filtrated to afford a solid. The resulting solid was Soxhlet extracted with acetone for 72 hours, then sedimentated with methanol and it was vacuum filtrated to give the title product in 59% yield. The Molecular weight of the product( GPC, THF, R. I): Mₙ = 22000, M_{w}/Mₙ = 2.3).

**Example 8**

The conjugated polymer of this Example is 4,5- dialkyl- benzo [2,1-b :3,4-b'] dithiophene -2,3 bis (phenyl) quinoxaline conjugated polymer, it is represented by formula I₈:

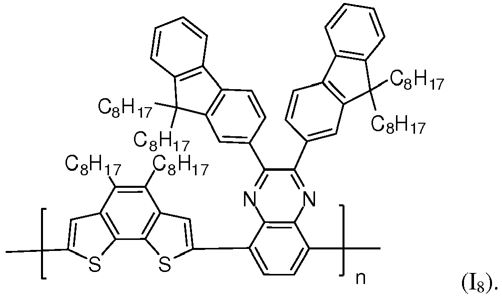

Preparation of the conjugated polymer of this Example is as follows:

1) Preparation of 5,8-dibromo-2,3-bis((2-(9,9-di-octylfluorene)yl)-quinoxaline, the chemical equation thereof is as follows:

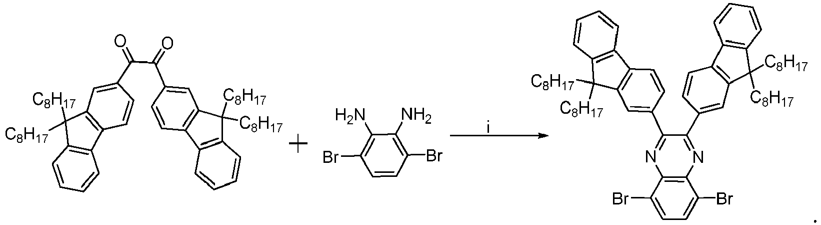

The detailed preparation procedure is: 3,6- dibromo- o-phenylene diamine (0.5 g, 1.85 mmol) was added to a solution of compound di-(9,9-di-octylfluorene)yl ethaneditone (0.42 g, 5.0 mmol) in a mixture (20 mL) of acetic acid and m-cresol with the volume ratio of 1:2 at 120° C, following mixed uniformly the mixture was refluxed for 18 hours. The resulting fluid reactant was poured into water, and neutralized with sodium bicarbonate until neutral, then extracted with chloroform and washed with saturated brine, dried over anhydrous sodium sulfate, and the solvent was removed by rotary evaporation to afford a crude product. The crude product was purified by column chromatography to afford a white solid, and then it was recrystallized from chloroform / n-hexane to give a solid powder. MS (MALDI) m/z: 1065.2 (M⁺).

2) A compound of 2,7 - bis-trimethyltin - 4,5-dialkylbenzo [2,1-b: 3,4-b'] dithiophene was prepared in the same procedure as step 2) in Example 1;

3) Synthesis of 4,5- dioctyl- benzo [2,1-b :3,4-b'] dithiophene -quinoxaline conjugated polymer of formula I₈, the chemical equation thereof is as follows:

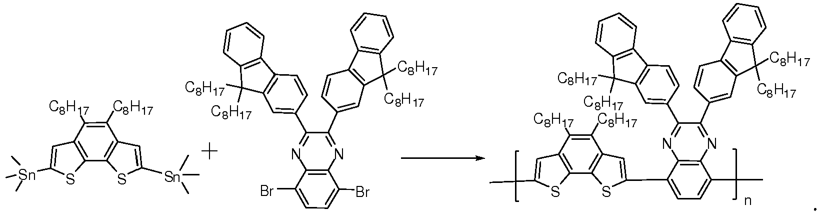

The detailed preparation procedure is: under the protection of nitrogen, a solution of compounds 5,8-dibromo-2,3-bis((2-(9,9-di-octyl fluorene)yl- quinoxaline (0.53 g, 0.5 mmol) and 2,7 - bis-trimethyltin - 4,5-dialkylbenzo [2,1-b: 3,4-b'] dithiophene (0.31 g, 0.5 mmol) in toluene (30 mL) was bubbled with nitrogen for 0.5 h to remove the oxygen in the reaction environment, then Pd₂(dba)₃ (0.014 g, 0.015 mol) and P(o-Tol)₃(0.0083 g, 0.027 mmol) were added, and the solution was bubbled with nitrogen for another 1 h to remove residual oxygen and then heated to 100°C under reflux for 72 hours. The resulting mixture was added dropwise to methanol to conduct a sedimentation, then vacuum filtrated, and washed with methanol and dried, then dissolved in chlorobenzene. The resulting solution was added to aqueous sodium diethyldithiocarbamate solution and heated to 80 °C with stirring for 12 hours, then it was allowed to stand until the layers separated. The resulting organic phase was passed through a column chromatography of alumina, eluted in chloroform, and concentrated under reduced pressure to remove the organic solvent, followed by methanol sedimentation and it was vacuum filtrated to afford a solid. The resulting solid was Soxhlet extracted with acetone for 72 hours, followed by methanol sedimentation and it was vacuum filtrated to give the title product in 56% yield. The Molecular weight of the product (GPC, THF, R. I): Mₙ = 10500, M_{w}/Mₙ = 2.3).

**Example 9**

The conjugated polymer of this Example is 4,5- dialkyl- benzo [2,1-b :3,4-b'] dithiophene -2,3 bis (phenyl) quinoxaline conjugated polymer, it is represented by formula I₉:

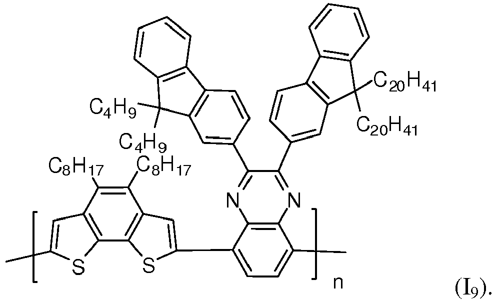

Preparation of the conjugated polymer of this Example is as follows:

1) A compound of 5,8-dibromo 2-(2-(9,9-di-octylfluorene)yl)-3- ((2-(9,9-di-n- eicosylfluorene)yl)-quinoxaline of following formula I₉' was prepared in the same procedure and under the similar condition as step 1) of Example 1;

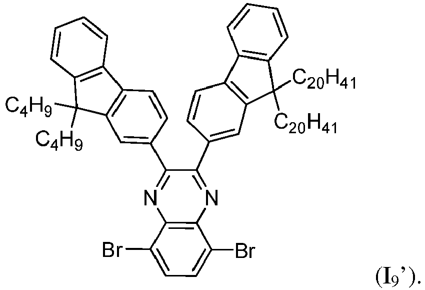

2) A compound of 2,7 - bis-trimethyltin - 4,5-dialkylbenzo [2,1-b: 3,4-b'] dithiophene was prepared in the same procedure as step 2) in Example 1;

3) Synthesis of 4,5-dioctylbenzo[2,1-b: 3,4-b'] dithiophene - quinoxaline conjugated polymer of formula I₉, the chemical equation thereof is as follows:

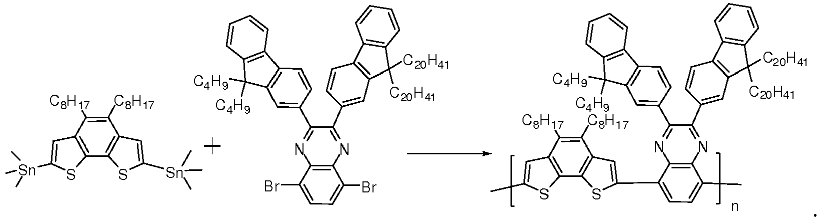

The detailed preparation procedure is: under the protection of nitrogen, a solution of compounds 5,8-dibromo 2-(2-(9,9-di-butylfluorene) yl)-3- ((2-(9,9-di-n-eicosylfluorene)yl)-quinoxaline (0.64 g, 0.5 mmol) and 2,7 - bis-trimethyltin - 4,5-dioctylbenzo [2,1-b: 3,4-b'] dithiophene (0.37 g, 0.5 mmol) in toluene (30 mL) was bubbled with nitrogen for 0.5 h to remove the oxygen in the reaction environment, then Pd₂(dba)₃(0.014 g, 0.015 mol) and P(o-Tol)₃ (0.0083 g, 0.027 mmol) were added, and the solution was bubbled with nitrogen for another 1 h to remove residual oxygen and then heated to 100° C under reflux for 72 hours. The resulting mixture was added dropwise to methanol to conduct a sedimentation, followed by vacuum filtration, and it was washed with methanol and dried, then dissolved in chlorobenzene. The resulting solution was added to aqueous sodium diethyldithiocarbamate solution and heated to 80 °C with stirring for 10 hours, then it was allowed to stand until the layers separated. The organic phase was passed through a column chromatography of alumina, eluted in chloroform, and concentrated under reduced pressure to remove the organic solvent, followed by methanol sedimentation and it was vacuum filtrated to give a solid. The resulting solid was Soxhlet extracted with acetone for 72 hours, followed by methanol sedimentation and it was vacuum filtrated to give the title product in 63% yield. The Molecular weight of the title product( GPC, THF, R. I): Mₙ = 94300, M_{w}/Mₙ = 3.1).

**Example 10**

The conjugated polymer of this Example is 4,5- dialkyl- benzo [2,1-b :3,4-b'] dithiophene -2,3 bis (phenyl) quinoxaline conjugated polymer, it is represented by formula I₁₀:

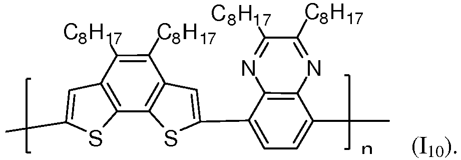

Preparation of the conjugated polymer of this Example is as follows:

1) Preparation of 5,8-dibromo-2,3-di-octyl -quinoxaline, the chemical equation thereof is:

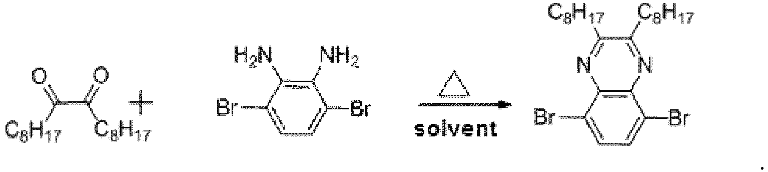

The detailed preparation procedure is:3,6- dibromo- o-phenylene diamine (0.5 g, 1.85 mmol) was added to a solution of compound di-octyl ethanedione (0.28 g, 1 mmol) in acetic acid(30 mL) at 120° C, the mixture was mixed uniformly and refluxed for 18 hours. The resulting fluid reactant was poured into water, and neutralized with sodium bicarbonate until neutral, then extracted with chloroform and washed with saturated brine, dried over anhydrous sodium sulfate, and the solvent was removed by rotary evaporation to give a crude product. The crude product was purified by column chromatography to give a white solid, then it was purified by recrystallization from chloroform / n-hexane to give the title product of this step. MS (EI) m/z: 512 (M⁺).

2) A compound of 2,7 - bis-trimethyltin - 4,5-dialkylbenzo [2,1-b: 3,4-b'] dithiophene was prepared in the same procedure as step 2) of Example 1;

3) Synthesis of 4,5-dioctylbenzo[2,1-b: 3,4-b'] dithiophene-2,3-dialkyl-quinoxaline conjugated polymer of formula I₁₀, the chemical equation thereof is as follows:

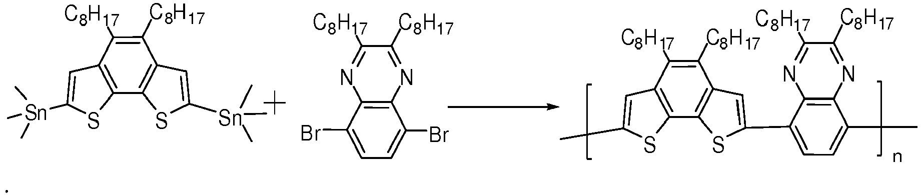

The detailed preparation procedure is: under the protection of nitrogen, a solution of compounds 5,8 - dibromo-2 ,3 - di-octyl- quinoxaline (0.26 g, 0.5 mmol) and 2,7 - bis-trimethyltin - 4,5-dialkylbenzo [2,1-b: 3,4-b'] dithiophene (0.37 g, 0.5 mmol) in toluenen (30mL) was bubbled with nitrogen for 0.5 h to remove the oxygen in the environment, then Pd₂(dba)₃ (0. 0.14 g, 0.015 mol) and P(o-Tol)₃ (0.0083 g, 0.027 mmol) were added, and the solution was bubbled with nitrogen for another 1 h to remove residual oxygen and then heated to 100 °C under reflux for 72 hours. The resulting mixture was added dropwise to methanol was to conduct a sedimentation, then it was vacuum filtrated, washed with methanol and dried, and dissolved in chlorobenzene. The resulting solution was added to aqueous sodium diethyldithiocarbamate solution, and the mixture was heated to 80 °C with stirring for 12 hours, then the mixture was allowed to stand until the layers separated. The resulting organic phase was passed through a column chromatography of alumina, eluted in chloroform, and concentrated under reduced pressure to remove the organic solvent, followed by methanol sedimentation and it was vacuum filtrated to give a solid. The resulting solid was Soxhlet extracted with acetone for 72 hours, followed by methanol sedimentation and it was vacuum filtrated to give the title product in 44% yield. The Molecular weight of the title product (GPC, THF, R. I): Mₙ = 85000, M_{w}/Mₙ = 1.7).

**Example 11**

The conjugated polymer of this Example is 4,5- dialkyl- benzo [2,1-b: 3,4-b'] dithiophene -2,3 bis (phenyl) quinoxaline conjugated polymer, it is represented by formula I₁₁:

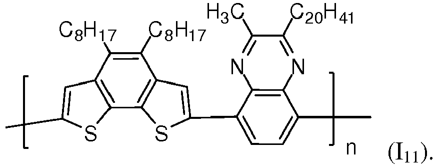

Preparation of the conjugated polymer of this Example is as follows:

1) A compound of 5,8-dibromo 2-methyl-3- n-eicosyl-quinoxaline of following formula I₁₁' was prepared in the same procedure and under the similar condition as step 1) of Example 10;

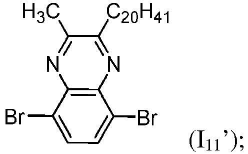

2) A compound of 2,7 - bis-trimethyltin - 4,5-dialkylbenzo [2,1-b: 3,4-b'] dithiophene was prepared in the same procedure as step 2) in Example 1;

3) Synthesis of 4,5-dioctylbenzo[2,1-b: 3,4-b'] dithiophene - quinoxaline conjugated polymer of formula I₁₁, the chemical equation thereof is as follows:

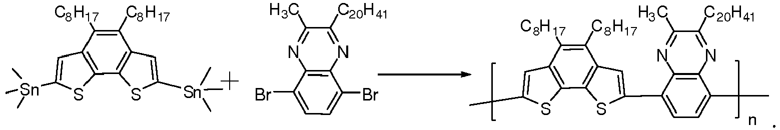

The detailed preparation procedure is: under the protection of nitrogen, a solution of compounds 5,8-dibromo 2-methyl -3-n- eicosyl -quinoxaline (0.29 g, 0.5 mmol), 2,7 - bis-trimethyltin - 4,5-dioctylbenzo [2,1-b: 3,4-b'] dithiophene (0.37 g, 0.5 mmol) in toluene (30 mL) was bubbled with nitrogen for 0.5 h to remove the oxygen in the reaction environment, then Pd₂(dba)₃ (0.014 g, 0.015 mol) and P(o-Tol)₃ (0.0083 g, 0.027 mmol) were added, and the solution was bubbled with nitrogen for another 1 h to remove residual oxygen and then heated to 100° C under reflux for 72 hours. The resulting mixture was added dropwise to methanol to conduct a sedimentation, then it was vacuum filtrated, and washed with methanol and dried, then dissolved in chlorobenzene. The resulting solution was added to aqueous sodium diethyldithiocarbamate solution and heated to 80 °C with stirring for 12 hours, then it was allowed to stand until the layers separated. The organic phase was passed through a column chromatography of alumina. The organic phase was passed through a column chromatography of alumina, eluted in chloroform, and concentrated under reduced pressure to remove the organic solvent, followed by methanol sedimentation and vacuum filtration, and a solid was obtained. The resulting solid was Soxhlet extracted with acetone for 72 hours, followed by methanol sedimentation and it was vacuum filtrated to give the title product in 55% yield. The Molecular weight of the title product( GPC, THF, R. I): *M*ₙ = 38000, M_{w}/Mₙ = 1.9).

**Application Example 12**

Preparation of solar cell device containing the polymer made in Example 1 as an active layer:

As shown in FIG. 2, the solar cell device comprises a glass substrate 11, a transparent anode 12, a middle auxiliary layer 13, an active layer 14, a cathode 15 in a stacked structure, wherein the middle auxiliary layer 13 is made from poly(3,4-ethylenedioxythiophene): polystyrene-sulfonic acid composite(abbreviated as PEDOT:PSS), the active layer 14 includes an electron donor material and an electron acceptor material, and the electron donor material is made from the polymer made in Example 1, the electron acceptor material may be [6,6]phenyl- C₆₁- butyric acid methyl ester(abbreviated as PCBM). The transparent anode 12 may be made from Indium Tin Oxide(abbreviated as ITO), preferably from the Indium Tin Oxide with the sheet resistance of 10-20 Ω/ . The cathode 15 may be an aluminum electrode or a double metal layers electrode, for example, Ca/Al, or Ba/A1 and the like. The glass substrate 11 may be used as the bottom layer. In manufacturing, an ITO glass is selected, then it is ultrasonic washed, and treated with Oxygen-Plasma, then the middle auxiliary layer 13 is coated on the ITO glass, and the polymer made in Example 1 and the electro acceptor material are blended before coated on the middle auxiliary layer 13 to form the active layer 14 thereon, then the cathode 15 is deposited on the active layer 14 by vacuum evaporation to obtain the solar cell device. In a preferred embodiment, the thicknesses of the transparent anode 12, middle auxiliary layer 13, active layer 14, double metal layer Ca and Al layer are 170, 40, 150, 70 nm respectively.

As shown in FIG. 2, under illumination ,the light passes through the glass substrate 11 and the ITO electrode 12, and the polymer made in Example 1 in the active layer 14 absorbs light energy and generates exactions, then the exactions migrate to the interface between the electron donor / acceptor materials, and the electron is transferred to the electron acceptor material, such as PCBM, so as to achieve the separation of the charge, and produce free carriers, i.e. free electrons and holes. These free electrons are transferred along the electron acceptor material towards the metal cathode and collected by the cathode, meanwhile the free holes are transferred along the electron donor material towards the ITO anode and collected by the anode, to give photocurrent and photovoltage, and the photoelectric conversion is achieved. When there is an external load 16 connected to the device, the device will supply power to the external load. In this process, the polymer prepared in Example 1 may utilize the light energy more sufficiently due to its very wide spectral response range, and have higher photoelectric conversion efficiency, thus the power production capacity of the solar cell device is increased. Furthermore this organic material may reduce the weight of the solar cell device containing the same, and can be produced by spin coating technology, and may be prepared in great numbers.

**Application Example 13**

Preparation of organic electroluminescence apparatus containing the polymer made in Example 1:

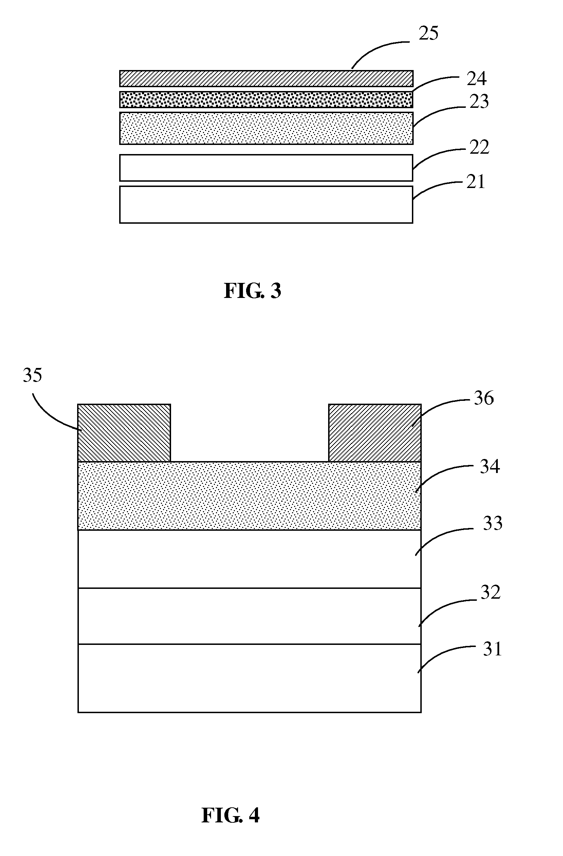

As shown in FIG. 3, an organic electroluminescence apparatus containing the polymer made in Example 1 is shown, the apparatus includes a glass substrate 21, a transparent anode 22, a luminescent layer 23, a buffer layer 24 and a cathode 25 in a stacked structure. The transparent anode 22 may be made from Indium Tin Oxide(abbreviated as ITO), preferably from the Indium Tin Oxide with the sheet resistance of 10-20 Ω/ . The luminescent layer 23 includes the polymer prepared in the Example 1. The buffer layer 24 may be made from LiF and the like, but not limited thereto. The cathode 25 may be Al and the like, but not limited thereto. Therefore, in a particular embodiment, the organic electroluminescence apparatus may be represented by the structure: ITO/the polymer made in Example 1/LiF/Al. Each of the layers may be made by exiting methods, and the polymer made in Example 1 may be formed on the ITO by spin coating. The LiF buffer layer may be vacuum evaporated on the luminescent layer, and the metal Al may be evaporated on the buffer layer and used as a cathode of the apparatus.

**Application Example 14**

Preparation of organic field effect transistor containing the polymer made in Example 1:

As shown in FIG. 4, the organic field effect transistor contains a substrate 31, an insulating layer 32, a modifying layer 33, an organic semi-conductor layer 34 and a source electrode 35 and a drain electrode 36 disposed on the organic semi-conductor layer 34 in a stacked structure. Wherein the substrate 31 may be, but not limited to heavy doped silicon(Si), the insulating layer 32 may be, but not limited to, SiO₂ with the thickness of micro-nanometer (e.g., 450 nm). The organic semi-conductor layer 34 is made of the polymer prepared in Example 1. Both of the source electrode 35 and the drain electrode 36 may be made from aurum, but not limited thereto. The modifying layer 33 may be, but not limited to, octadecyl trichlorosilane(OTS). Each of the substrate 31, the insulating layer 32, the modifying layer 33 and the source electrode 35 and the drain electrode 36 may be made by exiting methods. The organic semi-conductor layer 34 may be made by spin coating the polymer prepared in the Example 1 on the insulating layer 32 modified by modifying layer 33.

The embodiments above are merely the preferable embodiments of the present invention and not intended to limit the present invention. And all changes, equivalent substitution and improvements which come within the meaning and range of equivalency of the present invention are intended to be embraced therein.

## Claims

1. A quinoxaline conjugated polymer containing fused-ring thiophene unit, the general formula thereof is formula (I) as follows: 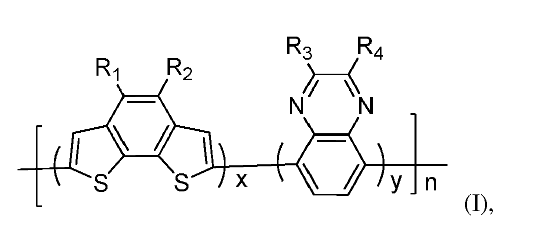 wherein, x+y =2, 1≤x < 2, n is an integer and 1< n ≤ 100, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl.

2. The quinoxaline conjugated polymer containing fused-ring thiophene unit of claim 1, wherein
the general formula of the fluorenyl group containing alkyl is as follows: 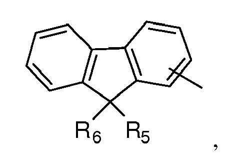 wherein R₅ and R₆ are same or different, and each represents a C₁ ∼ C₂₀ alkyl,
the general formula of the carbazyl group containing alkyl is as follows: 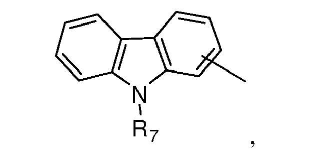 wherein R₇ is C₁ ∼ C₂₀ alkyl,
and the general formula of the benzene ring group containing alkyl is as follows: 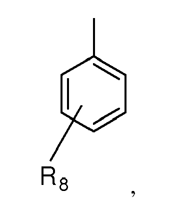 wherein R₈ is selected from the group consisting of C₁∼C₂₀ alkyl and C₁∼C₂₀ alkoxyl.

3. A method for manufacturing a quinoxaline conjugated polymer containing fused-ring thiophene unit, comprising:
compounds A, B and C with following formulae are provided separately, 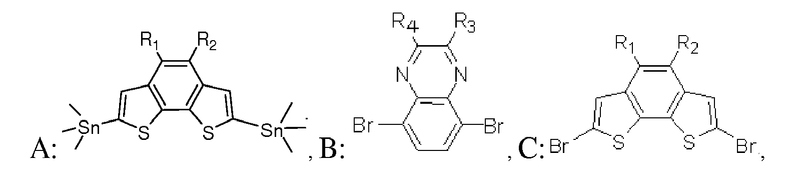 wherein, R₁ and R₂ are independently selected from C₁∼C₂₀ alkyl, R₃ and R₄ are independently selected from the group consisting of -H, C₁∼C₂₀ alkyl, C₁∼C₂₀ alkoxyl, benzene ring group containing alkyl or alkoxyl, fluorenyl group containing alkyl and carbazyl group containing alkyl;
under an inert gas atmosphere and with the present of catalyst and organic solvent, the Stille coupling of compounds A, B, C in a molar ratio of m:p:q is carried out to give the quinoxaline conjugated polymer containing fused-ring thiophene unit represented by general formula (I), wherein, m = p + q , and m > q≥0 , 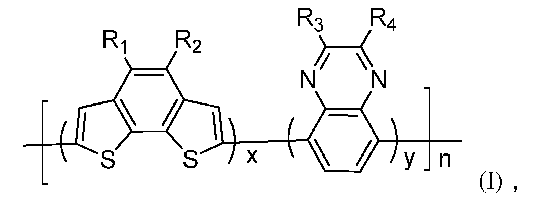 in general formula (I), x + y = 2, 1≤x < 2 , n is an integer and 1 < n≤100.

4. The method for manufacturing a quinoxaline conjugated polymer containing fused-ring thiophene unit of claim 3, wherein the method for producing compound B comprises:
at 20 ∼ 120° C and with the present of organic solvent, the dehydration reaction of compounds diketone and 3,6 - dibromo-o-phenylenediamine in a molar ratio of 1: 0.1~10 are carried out for 1 ∼ 24 h to give the said compound B.

5. The method for manufacturing a quinoxaline conjugated polymer containing fused-ring thiophene unit of claim 4, wherein the organic solvent employed in the dehydration reaction is at least one selected from the group consisting of acetic acid, m-cresol, p-toluenesulfonic acid, chloroform, methanol, ethanol and butanol.

6. The method for manufacturing a quinoxaline conjugated polymer containing fused-ring thiophene unit of claim 3, wherein, the amount of the catalyst in the said Stille coupling reaction is 0.05% ∼ 50% molar percent of compound A;
the said catalyst is an organic Pd catalyst or a blend of organic Pd catalyst and organic phosphine ligand;
the temperature of the said Stille coupling reaction is 60 ∼ 130° C, and the duration thereof is 24 ∼ 72h.

7. The method for manufacturing a quinoxaline conjugated polymer containing fused-ring thiophene unit of claim 3 or 6, wherein the catalyst is a blend of organic Pd catalyst and organic phosphine ligand and organic phosphine ligand, the molar ratio of the organic Pd catalyst/organic phosphine ligand is 1:2 ∼ 20.

8. The method for manufacturing a quinoxaline conjugated polymer containing fused-ring thiophene unit of claim 6, wherein the said organic Pd catalyst is at least one selected from the group consisting of Pd₂(dba)₃, Pd(PPh₃)₄, Pd(PPh₃)₂Cl₂;
the said organic phosphine ligand is P(o-Tol)₃ ;
the said organic solvent employed in the said Stille coupling reaction is one or more selected from the group consisting of tetrahydrofuran, ethylene glycol dimethyl ether, benzene, chlorobenzene and toluene.

9. The method for manufacturing a quinoxaline conjugated polymer containing fused-ring thiophene unit of claim 3, wherein when R₃ and R₄ are independently selected from the group consisting of benzene ring group containing alkyl or alkoxyl, fluorenyl group containing alkyl and carbazyl group containing alkyl, the general formula of the fluorenyl group containing alkyl is as follows: 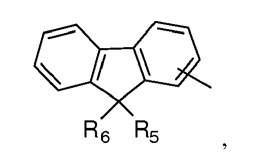 wherein R₅ and R₆ are same or different, and each represents a C₁ ∼ C₂₀ alkyl, the general formula of the carbazyl group containing alkyl is as follows: 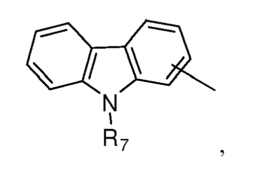 wherein R₇ is C₁ ∼ C₂₀ alkyl,
and the general formula of the benzene ring group containing alkyl is as follows: 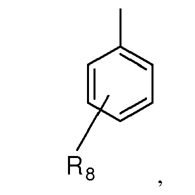 wherein R₈ is selected from the group consisting of C₁~C₂₀ alkyl and C₁~C₂₀ alkoxyl.

10. The use of the quinoxaline conjugated polymer containing fused-ring thiophene unit of claim 1 or 2 in the field of organic photoelectricity materials, polymer solar cells, organic electroluminescent elements, organic field effect transistors, organic optical storage elements, organic nonlinear materials and/or organic laser elements.
